(19) **Europäisches Patentamt / European Patent Office / Office européen des brevets**

(11) **EP 1 947 765 B1**

(12) **EUROPEAN PATENT SPECIFICATION**

(45) Date of publication and mention
of the grant of the patent:
**11.04.2012 Bulletin 2012/15**

(51) Int Cl.:
*H03H 9/02* (2006.01)     *H03H 3/10* (2006.01)
*H01L 41/09* (2006.01)     *H01L 41/18* (2006.01)
*H01L 41/22* (2006.01)

(21) Application number: **06811192.1**

(22) Date of filing: **04.10.2006**

(86) International application number:
**PCT/JP2006/319852**

(87) International publication number:
**WO 2007/046236 (26.04.2007 Gazette 2007/17)**

(54) **Lamb wave device**

Lamb-Wellen-Anordnung

Dispositif à onde de Lamb

(84) Designated Contracting States:
**AT BE BG CH CY CZ DE DK EE ES FI FR GB GR
HU IE IS IT LI LT LU LV MC NL PL PT RO SE SI
SK TR**

(30) Priority: **19.10.2005 JP 2005304218**

(43) Date of publication of application:
**23.07.2008 Bulletin 2008/30**

(73) Proprietor: **Murata Manufacturing Co. Ltd.
Nagaokakyo-shi, Kyoto-fu 617-8555 (JP)**

(72) Inventors:
• **OGAMI, Takashi
Nagaokakyo-shi, Kyoto 617-8555 (JP)**
• **YAMAMOTO, Kansho
Nagaokakyo-shi, Kyoto 617-8555 (JP)**
• **KADOTA, Michio
Nagaokakyo-shi, Kyoto 617-8555 (JP)**

(74) Representative: **Thévenet, Jean-Bruno et al
Cabinet Beau de Loménie
158, rue de l'Université
75340 Paris Cédex 07 (FR)**

(56) References cited:
**JP-A- 2002 152 007     JP-A- 2003 309 447
JP-A- 2004 072 204     US-A- 5 003 822**

• **KOICHI MIZUTANI; KOHJI TODA: "Analysis of
Lamb Wave Propagation Characteristics in
Rotated Y-Cut X-Propagation LiNbO3"
ELECTRONICS AND COMMUNICATIONS IN
JAPAN, vol. 69, no. 4, April 1986 (1986-04), pages
47-55, XP002537663 USA**
• **KOHJI KODA; KOICHI MIZUTANI: "Propagation
Characteristics of Plate Waves in a Z-Cut X-
Propagation LiTaO3 Thin Plate" ELECTRONICS
AND COMMUNICATIONS IN JAPAN, vol. 72, no.
8, August 1989 (1989-08), pages 11-21,
XP002537664**
• **YU JIN; SHRINIVAS G. JOSHI: "Characteristics of
Ultrasonic Lamb Waves in 128° Rotated Y-Cut
Lithium Niobate" IEEE TRANSACTIONS ON
ULTRASONICS, FERROELECTRICS, AND
FREQUENCY CONTROL, vol. 41, no. 2, March
1994 (1994-03), pages 279-283, XP002537665 USA**

Printed by Jouve, 75001 PARIS (FR)

**Description**

Technical Field

The present invention relates to a Lamb wave device using a Lamb wave propagating in a piezoelectric thin film, and more particularly relates to a Lamb wave device used as a resonator or a filter.

Background Art

Heretofore, devices using various waves excited using a piezoelectric effect have been proposed and have also been used. Among these devices, devices using a surface acoustic wave, that is, energy that concentrates in the vicinity of a surface of an elastic body and propagates, have been widely used as a resonator, a filter, and the like.
On the other hand, according to the following Non-Patent Document 1, a device using a Lamb wave propagating in an elastic body, which is different from a Rayleigh wave, has been disclosed. The Lamb wave is one type of bulk waves, that is, one type of so-called plate waves, and is an elastic wave which propagates in a piezoelectric body while reflecting on two primary surfaces thereof when the thickness of the piezoelectric body is equivalent to or less than the wavelength of the elastic wave. As the plate wave, besides the Lamb wave, an SH wave has also been known. According to "Handbook of Elastic Wave Device Technology" (published in 1991 by Ohm Co., Ltd.), it has been disclosed that "the mode change of an SV wave and that of a longitudinal wave (compressional wave) occur at two surfaces of a plate, and by complicated coupling therebetween, a plate wave called a Lamb wave is generated".
As disclosed in the Non-patent Document 1, since the Lamb wave, which is an elastic wave, propagates in a plate-shaped piezoelectric body while reflecting on two surfaces of the plate-shaped elastic body, the properties of the Lamb wave are different from those of the Rayleigh wave. In the Lamb wave, since velocity dispersion properties are present, two surfaces can be used, and hence, it may be able to obtain a larger electromechanical coupling coefficient than that of the Rayleigh wave.
In the Non-Patent Document 1, a Lamb wave device using a piezoelectric thin film of 90°-rotated Y-X $LiNbO_3$ has been disclosed. In this document, it has been disclosed that the A1 mode, which is an asymmetric mode having a high acoustic velocity and a large electromechanical coupling coefficient, is excited.
Non-Patent Document 1: "Analysis of Lamb wave propagation characteristics in rotated Y-cut X-propagation LiNbO3 plate" The Journal of the Institute of Electrical Communication Engineers of Japan, 85/5, Vol. J68-A, No. 5, pp. 496-503.
US 5,003,822 describes a Lamb wave device incorporating a floating piezoelectric membrane. The membrane may be a piezoelectric thin film deposited on a semiconductor substrate or may use a $LiNbO_3$ substrate. The lowest order asymmetric propagation mode ($A_0$) is used.
JP 2002-152007 describes a Lamb wave resonator using a $LiNbO_3$ single crystal membrane. The $LiNbO_3$ thin film has its orientation rotated around the X axis from the Y axis toward the Z axis at angles within the range -10 to 70°.

Disclosure of Invention

According to the above Lamb wave device disclosed in the Non-Patent Document 1, since the Lamb wave is used in the structure in which an IDT electrode is formed on a piezoelectric thin film, it is pointed out that the electromechanical coupling coefficient is probably increased. However, when a Lamb wave device as disclosed in the Non-Patent Document 1 is actually formed, although a pass band can be obtained in a high frequency region, a spurious response is disadvantageously liable to be generated in the pass band or attenuation band.
An object of the present invention is to solve the above problem of the conventional technique and is to provide a Lamb wave device which is not only able to obtain a higher bandwidth by increasing the electromechanical coupling coefficient but is also able to suppress the influence of undesired spurious responses.
According to a broad aspect of the present invention, there is provided a Lamb wave device comprising: a base substrate; a piezoelectric thin film which is formed on the base substrate and which has a floating portion floating above the base substrate, the floating portion having a first surface facing the base substrate and a second surface opposite to the first surface; and an IDT electrode disposed on at least one of the first and the second surfaces of the piezoelectric thin film. In this Lamb wave device, the piezoelectric thin film is formed of $LiTaO_3$ or $LiNbO_3$, and the c axis of the piezoelectric thin film is set in approximately the same direction as that of the normal line to the first and the second surfaces of the piezoelectric thin film, and the crystal structure of the piezoelectric thin film is a rotation twin crystal having the c axis functioning as the rotation axis.
According to a specific aspect of the Lamb wave device of the present invention, the piezoelectric thin film is formed of $LiNbO_3$, the IDT electrode is formed of Al or an alloy containing Al as a primary component, and when the thickness of the IDT electrode is represented by h, the thickness of the piezoelectric thin film is represented by d, and the wavelength of a usage mode of the Lamb wave is represented by $\lambda$, h and d satisfy one of the following conditions I to III.

$$\text{I} \quad 0.01 \leq h/d \leq 0.24 \text{ and } 0.090 \leq d/\lambda \leq 0.107$$

$$\text{II} \quad 0.01 \leq h/d \leq 0.24 \text{ and } 0.133 \leq d/\lambda \leq 0.233$$

$$\text{III} \quad 0.01 \leq h/d \leq 0.24 \text{ and } 0.257 \leq d/\lambda \leq 0.300$$

According to another specific aspect of the Lamb wave device of the present invention, the piezoelectric thin film is formed of $LiTaO_3$, the IDT electrode is formed of Al or an alloy containing Al as a primary component, and when the thickness of the IDT electrode is represented by h, the thickness of the piezoelectric thin film is represented by d, and the wavelength of a usage mode of the Lamb wave is represented by $\lambda$, h and d satisfy one of the following conditions IV to VI.

$$\text{IV} \quad 0.01 \leq h/d \leq 0.26 \text{ and } 0.093 \leq d/\lambda \leq 0.125$$

$$\text{V} \quad 0.01 \leq h/d \leq 0.26 \text{ and } 0.141 \leq d/\lambda \leq 0.240$$

$$\text{VI} \quad 0.01 \leq h/d \leq 0.26 \text{ and } 0.260 \leq d/\lambda \leq 0.300$$

According to another specific aspect of the Lamb wave device of the present invention, the IDT electrode is formed on the second surface of the piezoelectric thin film.

In addition, according to another specific aspect of the present invention, the IDT electrode is formed on the first surface of the piezoelectric thin film.

(Advantages)

In the Lamb wave device of the present invention, since the piezoelectric thin film is formed of $LiTaO_3$ or $LiNbO_3$, the c axis is set in approximately the same direction as that of the normal line to the first and the second surfaces of the piezoelectric thin film, and the crystal structure thereof is a rotation twin crystal, the fundamental mode S0 of the symmetric mode and/or the fundamental mode SH0 of the SH mode is not generated, and out-of-band spurious responses based on these modes can be suppressed. Hence, a Lamb wave device having superior frequency properties can be provided.

Hence, according to the present invention, for example, a device having a central frequency of 2 to 10 GHz and a fractional band width of 1% to 10% can be provided. Furthermore, besides a band-pass filter, the Lamb wave device of the present invention may be applied to various devices, such as a resonator.

In particular, according to the present invention, when the piezoelectric thin film is formed of $LiNbO_3$, the IDT electrode is formed of Al or an alloy containing Al as a primary component, and h and d satisfy one of the above conditions I to III, the generation of spurious responses in the vicinity of the pass band can be effectively suppressed, and hence ripples generated in the pass band and spurious responses in the vicinity of the pass band can be suppressed.

In addition, when the piezoelectric thin film is formed of $LiTaO_3$, the IDT electrode is formed of Al or an alloy containing Al as a primary component, and h and d satisfy one of the above conditions IV to VI, as is the case described above, the generation of spurious responses in the vicinity of the pass band can be suppressed, and hence ripples generated in the pass band and spurious responses in the vicinity of the pass band can be effectively suppressed.

When the IDT electrode is formed on the second surface of the piezoelectric thin film, which is a surface opposite to that facing the base substrate, since the IDT electrode can be easily formed on the second surface of the piezoelectric thin film provided on the base substrate, the Lamb wave device can be provided.

Furthermore, the IDT electrode may be formed on the first surface of the piezoelectric thin film, and in this case, since the IDT electrode faces the base substrate and is not exposed outside, a metal powder generated from a metal material forming an exterior packaging case is not likely to adhere to the IDT electrode. Hence, property defects caused by the adhesion of a metal powder or the like can be suppressed, and a Lamb wave device having superior environmental resistance and/or humidity resistance can be provided.

Brief Description of Drawings

Fig. 1 is a schematic front cross-sectional view of a Lamb wave device according to one embodiment of the present invention.

Fig. 2 is a view showing an XRD spectrum of a $LiNbO_3$ thin film formed on a ZnO epitaxial film.

Fig. 3A is a view showing the result, which is obtained by actual measurement, of the change in impedance with the acoustic velocity when a $LiNbO_3$ thin film of a Lamb wave device of an embodiment has a twin crystal structure.

Fig. 3B is a view showing the result, which is obtained by simulation, of the change in impedance with the acoustic velocity when a $LiNbO_3$ thin film of a Lamb wave device of an embodiment has a twin crystal structure.

Fig. 3C is a view showing the relationship between the impedance and the acoustic velocity, which is obtained by simulation when a $LiNbO_3$ thin film has a single crystal structure.

Fig. 4 is a view showing the change in electromechanical coupling coefficient $K^2$ with h/d of each mode in which in a Lamb wave device of an embodiment, an IDT electrode is formed on a $LiNbO_3$ thin film using Al, and the ratio $d/\lambda$ of a thickness d of the electrode to a wavelength $\lambda$ is set to 0.10.

Fig. 5 is a view showing the change in electromechanical coupling coefficient $K^2$ of each mode of a Lamb wave when h/d is set to 0.24, and the ratio $d/\lambda$ is changed in the range of 0.08 to 0.3.

Fig. 6 is a view showing the change in electromechanical coupling coefficient $K^2$ with h/d of each mode in which in a Lamb wave device of an embodiment, the IDT electrode is formed on a $LiTaO_3$ thin film using Al, and the ratio $d/\lambda$ of the thickness d of the electrode to the wavelength $\lambda$ is set to 0.10.

Fig. 7 is a view showing the change in electromechanical coupling coefficient $K^2$ with $d/\lambda$, of each mode in which in a Lamb wave device of an embodiment, the IDT electrode is formed on a $LiTaO_3$ thin film using Al, and the ratio h/d of the thickness d of the electrode to the wavelength $\lambda$ is set to 0.26.

Reference Numerals

1    Lamb wave device
2    base substrate
3    piezoelectric thin film
3a    first surface
3b    second surface
4    IDT electrode

Best Modes for Carrying Out the Invention

Hereinafter, with reference to the drawings, concrete embodiments of the present invention will be described, so that the present invention will be disclosed in detail.

(Experimental Example 1)

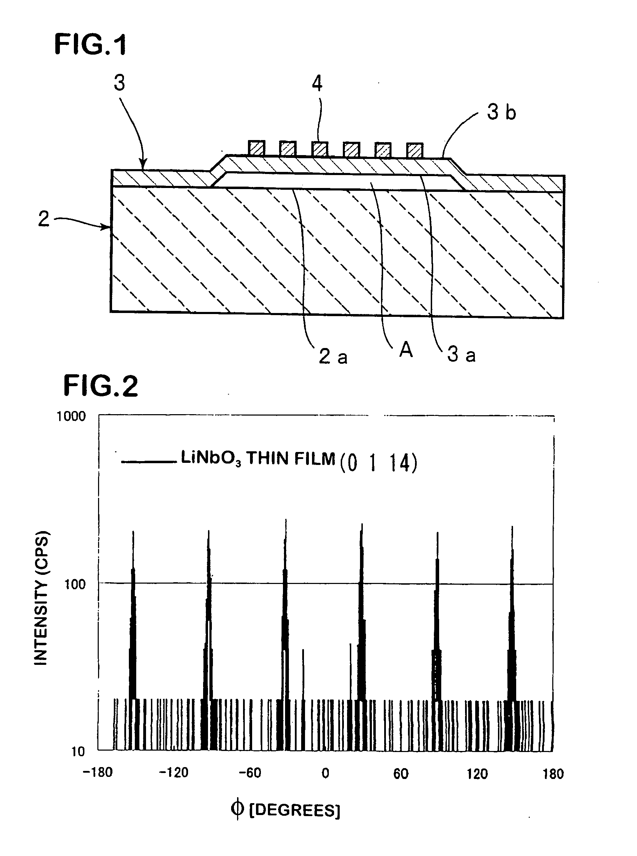

Fig. 1 is a schematic front cross-sectional view illustrating a Lamb wave device according to one embodiment of the present invention. A Lamb wave device 1 has a base substrate 2 and a piezoelectric thin film 3 formed thereon. The piezoelectric thin film 3 is formed on an upper surface 2a of the base substrate 2; however, a floating part of the piezoelectric thin film 3 is provided above the upper surface 2a of the base substrate 2 with a gap interposed therebetween. At this floating part, a first surface 3a of the piezoelectric thin film 3 faces the upper surface 2a of the base substrate 2 with the gap interposed therebetween, and an IDT electrode 4 is formed on a second surface 3b which is an outer surface and which is a surface opposite to the first surface 3a. The IDT electrode 4 is provided to form a desired resonator or filter.

In this embodiment, the base substrate 2 is formed of a $LiNbO_3$ single crystal substrate. In addition, the piezoelectric thin film 3 is formed of a $LiNbO_3$ thin film, the c axis of the piezoelectric thin film 3 is set in approximately the same direction as that of the normal line to the first and the second surfaces 3a and 3b of the piezoelectric thin film 3, and the crystal structure of the piezoelectric thin film 3 is a rotation twin crystal having the c axis functioning as the rotation axis.

By description of a method for manufacturing the Lamb wave device of this embodiment, the above structure will be described in more detail.

First, on the base substrate 2, by a general film formation method, such as sputtering, a ZnO epitaxial film used as an underlying layer is formed so that the c axis is in a direction perpendicular to the upper surface 2a of the base substrate 2.

A material forming the base substrate 2 is not limited to the above material as,long as an epitaxial film can be formed thereon so that the c axis is in a direction approximately perpendicular to the upper surface 2a of the base substrate 2. For example, the base substrate 2 may be formed of another piezoelectric single crystal, such as a $LiTaO_3$ single crystal or sapphire.

After the ZnO epitaxial film used as an underlying layer is patterned in accordance with the planar shape of the floating part of the piezoelectric thin film 3 to be subsequently formed, by using a CVD film forming apparatus, the piezoelectric thin film 3 is formed. The piezoelectric thin film 3 is formed of a $LiNbO_3$ thin film in this embodiment. In addition, instead of the $LiNbO_3$ thin film, a $LiTaO_3$ thin film may also be formed.

Since the piezoelectric thin film 3 is formed on the ZnO epitaxial film thus formed as an underlying layer, the c axis of the piezoelectric thin film 3 is in a direction perpendicular to the upper surface 2a of the base substrate 2, and the piezoelectric thin film 3 formed of $LiNbO_3$ is a twin epitaxial film.

A $LiNbO_3$ single crystal or a $LiTaO_3$ single crystal naturally has 3-fold rotational symmetry around the c axis; however, after the piezoelectric thin film 3 was formed, when evaluation was performed using XRD, the result shown in Fig. 2 was obtained. That is, as apparent from an XRD spectrum shown in Fig. 2, it was confirmed that an actually formed $LiNbO_3$ thin film has 6-fold rotation symmetry. In addition, it was found that the $LiNbO_3$ film thus formed is a rotation twin epitaxial film.

Since the ZnO epitaxial film used as an underlying layer itself has 6-fold rotation symmetry, it is believed that $LiNbO_3$ or $LiTaO_3$ formed thereon has two orientation directions. As long as a $LiNbO_3$ thin film or a $LiNbO_3$ thin film can be a rotation twin epitaxial film, a material used as an underlayer is not limited to ZnO, an epitaxial film of a metal, such as Cu or Pt, may also be used.

Next, by a dry process, such as Ar ion milling or reactive ion etching, etching holes are formed in the above $LiNbO_3$ thin film or $LiTaO_3$ thin film. Subsequently, by using a photolithographic and a film forming method, the IDT electrode 4 is formed. Next, the ZnO epitaxial film used as an underlying layer is removed by etching using an acid, and as a result, a space A shown in Fig. 1 is formed.

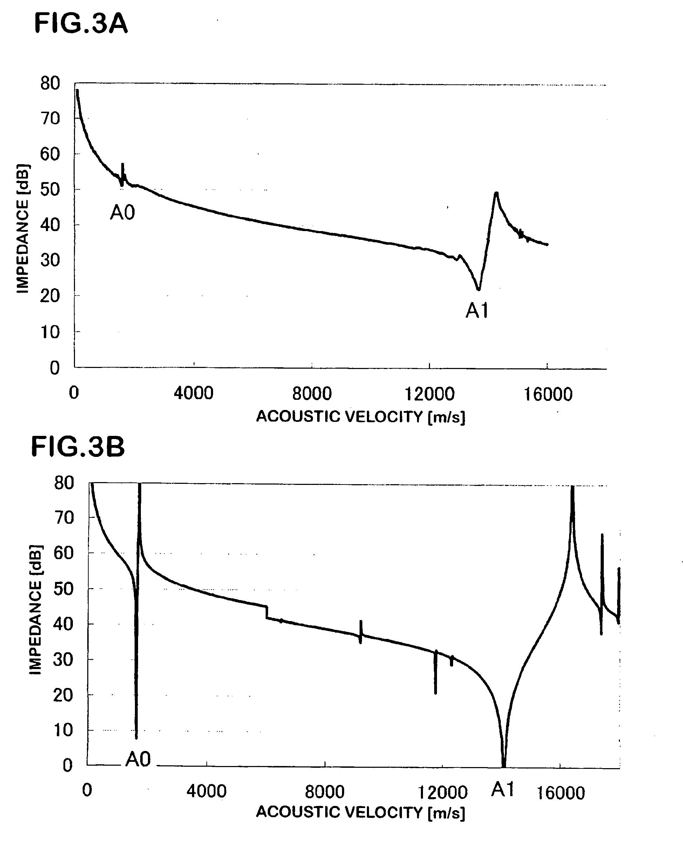

The Lamb wave device 1 of this embodiment is obtained as described above. The relationship between the acoustic velocity and the impedance of a resonator of the $LiNbO_3$ thin film of the Lamb wave device 1 was measured. The result is shown in Fig. 3A.

In addition, Fig. 3B shows the result, obtained by simulation, of the relationship between the acoustic velocity and the impedance of the $LiNbO_3$ thin film of the Lamb wave device 1, which was obtained by simulation using a finite element method.

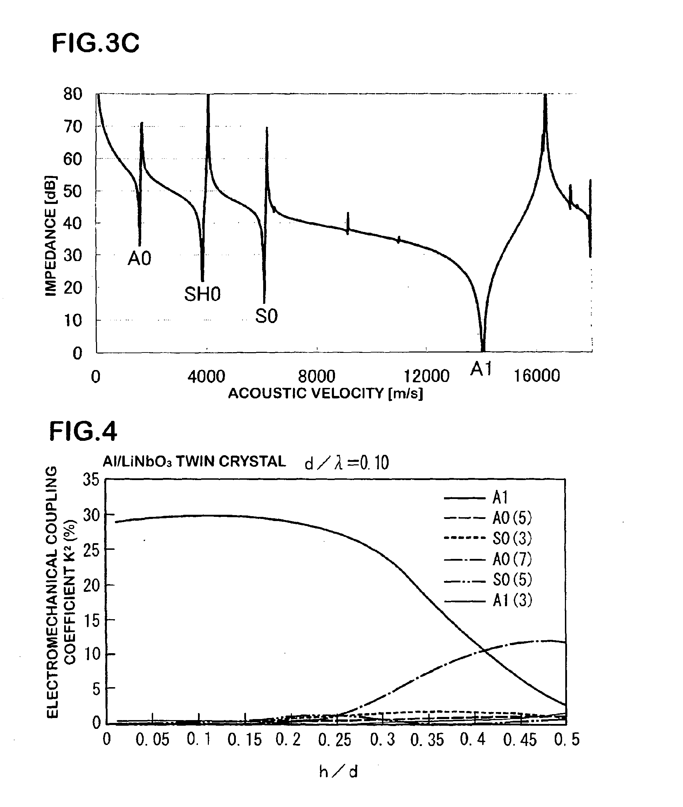

In addition, Fig. 3C is a view showing the relationship between the acoustic velocity and the impedance of the structure of a comparative example having the same configuration as described above except that a $LiNbO_3$ thin film of the Lamb wave device 1 has not a twin crystal structure but is a single crystal, which is obtained by simulation.

As apparent from Fig. 3C, it is found that when the $LiNbO_3$ thin film is a single crystal, intensive responses by the fundamental mode SH0 of the SH wave and the fundamental mode S0 that is, the symmetric mode, of the Lamb wave are observed, which are large spurious responses, are generated to the first order mode A1, that is, the anti-symmetric mode. On the other hand, from Figs. 3A and 3B, it is found that although responses by the anti-symmetric mode A1 are observed, the fundamental mode SH0 of the SH wave and the fundamental mode S0 of the symmetric mode, which cause degradation in attenuation band, are barely observed.

That is, since the piezoelectric thin film 3 has a twin crystal structure, it is found that undesired spurious responses can be effectively suppressed.

The results shown in Figs. 3B and 3C were obtained by a finite element method; in this embodiment, when the wavelength of the IDT was represented by $\lambda$, the thickness of the $LiNbO_3$ thin film is set to $0.155\lambda$, the IDT electrode 4 was formed of Al, the thickness thereof is set to $0.03\lambda$, and the duty ratio is set to 0.47. In addition, as for the twin crystal structure, the piezoelectric thin film portion was equally divided into 80 regions with respect to the elastic wave propagation direction, an Euler angle $(0°, 0°, \psi_0)$ portion and an Euler angle $(0°, 0°, \psi_0+180°)$ portion were alternately disposed, and $\psi_0$ is set to $15°$. In any propagation directions, the same result can be obtained as that obtained with respect to $\psi_0$.

In addition, although Figs. 3A to 3C show the results when the piezoelectric thin film 3 was a $LiNbO_3$ thin film, when a $LiTaO_3$ thin film was used, results similar to those described above could be obtained.

(Experimental Example 2)

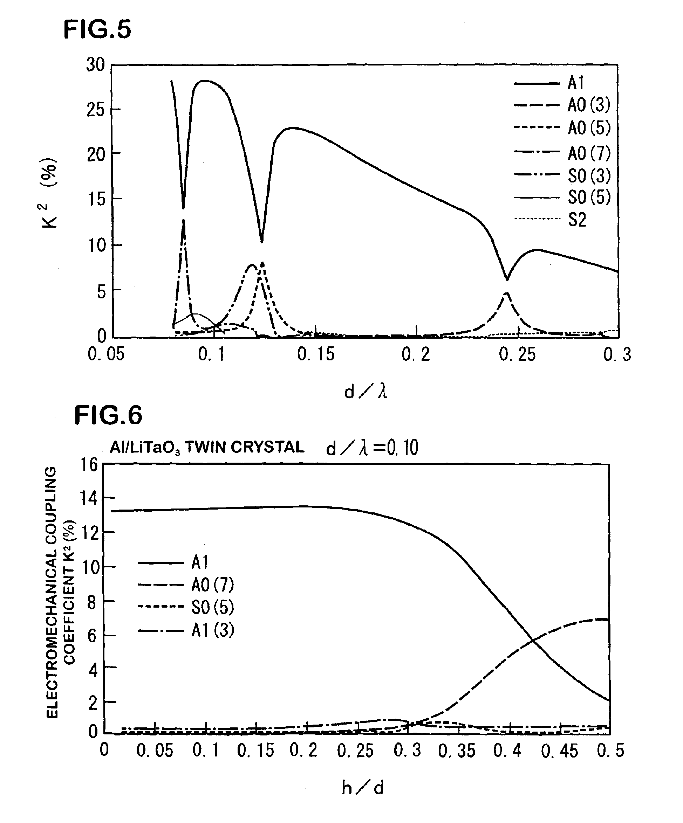

In a Lamb wave device similar to that in the Experimental Example 1, the electromechanical coupling coefficient of a Lamb wave was obtained when the thickness of the IDT electrode 4 and the thickness of the piezoelectric thin film 3 were variously changed. The results are shown in Figs. 4 and 5. In Figs. 4 and 5, h indicates the thickness of the IDT electrode, d indicates the thickness of the piezoelectric thin film, and $\lambda$ indicates the wavelength of a Lamb wave. In addition, for the calculation, a finite element method was used. Fig. 4 shows the change in electromechanical coupling coefficient of each mode of the Lamb wave with the change in h/d when d/$\lambda$ is set to 0.1. As apparent from Fig. 4, it is found that when h/d exceeds approximately 0.24, the electromechanical coupling coefficient $K^2$ of the A1 mode, which is the main mode, decreases, and that the electromechanical coupling coefficients of the other modes increase. Hence, it is found that when the upper limit of h/d is set to approximately 0.24 when d/$\lambda$ is set to 0.1, a Lamb wave device suppressing spurious response can be realized.

In addition, the notation of the individual modes of the Lamb wave shown in Fig. 4 is as described below. The mode of the Lamb wave is defined by Xn(i). That is, X indicates the type of mode, for example, A indicates the asymmetric mode, and S indicates the symmetric mode. In addition, "n" is an integer of 0 or more and indicates the order of the mode, that is, the number of nodes of the maximum displacement component in the thickness direction of the piezoelectric thin film. Furthermore, "i" is an integer of 1 or more and indicates the number of nodes of the maximum displacement component in a half-wavelength region in the propagation direction of the Lamb wave. In particular, when "i" is 1, the notation of (i) is omitted.

Next, the change in electromechanical coupling coefficient $K^2$ of each mode is shown when d/$\lambda$ was changed. Fig. 5 is a view showing the change in electromechanical coupling coefficient $K^2$ of each mode of the Lamb wave when h/d was fixed at 0.24 and d/$\lambda$ was changed in the range of 0.08 to 0.3. As apparent from Fig. 5, it is found that in several ranges of d/$\lambda$, the electromechanical coupling coefficient $K^2$ of the A1 mode, which is the main mode, decreases, and the electromechanical coupling coefficients $K^2$ of the other modes increase. The ranges of d/$\lambda$ as described above are not suitable for filters.

When the results shown in Figs. 4 and 5 are collectively taken into consideration, in the case in which h/d$\leq$0.24 holds, and d/$\lambda$ is within the range that satisfies the following I to III conditions:

$$\text{I}\quad 0.090\leq d/\lambda\leq 0.107$$

$$\text{II}\quad 0.133\leq d/\lambda\leq 0.233$$

$$\text{III}\quad 0.257\leq d/\lambda\leq 0.300,$$

the electromechanical coupling coefficient of the modes other than the A1 mode, which is the main mode, can be sufficiently suppressed to small, and as a result, the generation of spurious responses is suppressed, so that a Lamb wave device having favorable properties can be realized. In addition, besides Al used as a material for the IDT electrode, the same results as described above can be obtained even when an alloy containing Al as a primary component is used. When h/d is less than 0.01, due to the actual loss in an electric current concomitant with an increase in an electrical resistance of the electrode, the insertion loss is degraded; hence, h/d is preferably 0.01 or more.

(Experimental Example 3)

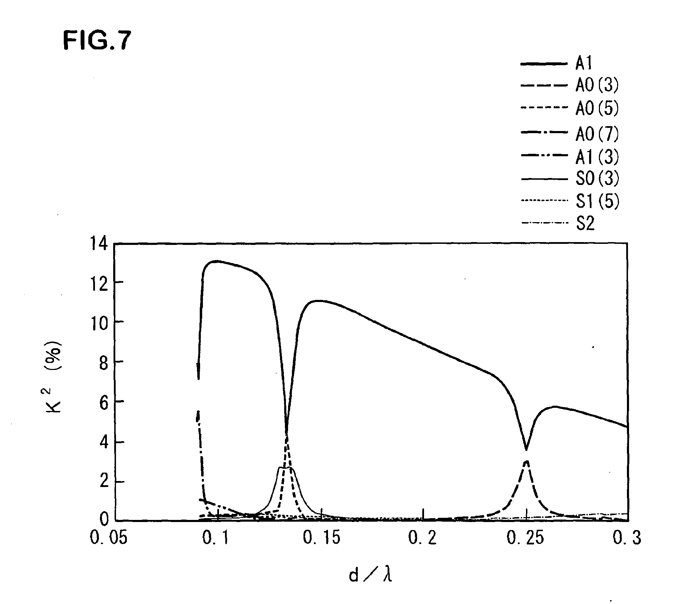

In Experimental Example 3, a basic structure similar to that of the Experimental Example 1 was prepared except that the base substrate 2 and the piezoelectric thin film 3 of the Lamb wave device of the Experimental Example 1 were formed of $LiTaO_3$. As the Experimental Example 2, the electromechanical coupling coefficient of a Lamb wave was obtained when the thickness of the IDT electrode 4 and that of the piezoelectric thin film 3 were variously changed. The results are shown in Figs. 6 and 7. As shown in Figs. 4 and 5, also in Figs. 6 and 7, h indicates the thickness of the IDT electrode, d indicates the thickness of the piezoelectric thin film, and $\lambda$ indicates the wavelength of the Lamb wave. In addition, for the calculation, a finite element method was used. Fig. 6 shows the change in electromechanical coupling coefficient of each mode of the Lamb wave with the change in h/d when d/$\lambda$ 1s set to 0.1. As apparent from Fig. 6, it is found that when h/d exceeds approximately 0.26, the electromechanical coupling coefficient $K^2$ of the A1 mode, which is the main mode, decreases, and the electromechanical coupling coefficients $K^2$ of the other modes increase.

Next, the change in electromechanical coupling coefficient of each mode is shown when d/$\lambda$ was changed. Fig. 7 is a view showing the change in electromechanical coupling coefficient $K^2$ of each mode of the Lamb wave when h/d was fixed at 0.26 and d/$\lambda$ was changed in the range of 0.08 to 0.3. As apparent from Fig. 7, it is found that in several ranges of d/$\lambda$, the electromechanical coupling coefficient $K^2$ of the A1 mode, which is the main mode, decreases, and the electromechanical coupling coefficients $K^2$ of the other modes increase. The ranges of $d/\lambda$ as described above are not suitable for filters.

When the results shown in Figs. 6 and 7 are collectively taken into consideration, in the case in which $h/d \leq 0.26$ holds, and $d/\lambda$ is within the range that satisfies the following IV to VI conditions:

$$\text{IV} \quad 0.093 \leq d/\lambda \leq 0.125$$

$$\text{V} \quad 0.141 \leq d/\lambda \leq 0.240$$

$$\text{VI} \quad 0.260 \leq d/\lambda \leq 0.300,$$

the electromechanical coupling coefficient of the modes other than the A1 mode, which is the main mode, can be sufficiently suppressed to small, and as a result, the generation of spurious responses is suppressed, so that a Lamb wave device having favorable properties can be realized. In addition, besides Al used as a material for the IDT electrode, the same results as described above can be obtained even when an alloy containing Al as a primary component is used. When h/d is less than 0.01, due to the actual loss in an electric current concomitant with an increase in an electrical resistance of the electrode, the insertion loss is degraded; hence, h/d is preferably 0.01 or more.

In addition, in the Lamb wave device 1 shown in Fig. 1, the IDT electrode 4 is formed on the second surface 3b of the piezoelectric thin film 3. In this case, since the IDT electrode 4 is formed on the upper surface of the piezoelectric thin film 3, that is, on the surface exposed outside, the IDT electrode 4 can be easily formed. Hence, an inexpensive Lamb wave device 1 can be provided.

Furthermore, the IDT electrode 4 may be formed on the first surface 3a of the piezoelectric thin film 3, that is, on the inside surface facing the base substrate 2. When the IDT electrode 4 is formed on the first surface 3a, which is the inside surface facing the space A, even when a metal powder and the like separated from an exterior packaging case metal falls, short-circuiting and/or property defects are not likely to occur. Hence, a Lamb wave device which is not likely to be varied by adhesion of a metal powder or the like and which has superior environmental resistance, such as humidity resistance, can be provided.

In addition, in this specification, the twin crystal is defined as one solid in which at least two single crystals of one substance are bonded to each other in accordance with a specific symmetric relationship. The rotation twin crystal having the c axis functioning as the rotation axis is defined as a twin crystal having a symmetric relationship which can be represented such that, when individual single crystals, that is, constituent elements, are represented by Euler angles, the Euler angles rotate to each other around the c axis.

## Claims

1. A Lamb wave device (1) comprising:

   a base substrate (2);
   a piezoelectric thin film (3) which is formed on the base substrate (2) and which has a floating portion floating above the base substrate, the floating portion having a first surface (3a) facing the base substrate and a second surface (3b) opposite to the first surface; and
   an IDT electrode (4) disposed on at least one of the first and the second surfaces (3a,3b) of the piezoelectric thin film,
   wherein the piezoelectric thin film (3) is formed of $LiTaO_3$ or $LiNbO_3$,
   **characterized in that** the c axis of the piezoelectric thin film is set in approximately the same direction as that of the normal line to the first and the second surfaces of the piezoelectric thin film, and the crystal structure of the piezoelectric thin film is a rotation twin crystal having the c axis functioning as the rotation axis.

2. The Lamb wave device according to Claim 1,
   wherein the piezoelectric thin film (3) is formed of $LiNbO_3$,
   the IDT electrode (4) is formed of Al or an alloy containing Al as a primary component, and
   when the thickness of the IDT electrode (4) is represented by h, the thickness of the piezoelectric thin film (3) is represented by d, and the wavelength of a usage mode of the Lamb wave is represented by $\lambda$, h and d satisfy one of the following conditions I to III:

$$I \quad 0.01 \leq h/d \leq 0.24 \text{ and } 0.090 \leq d/\lambda \leq 0.107$$

$$II \quad 0.01 \leq h/d \leq 0.24 \text{ and } 0.133 \leq d/\lambda \leq 0.233$$

$$III \quad 0.01 \leq h/d \leq 0.24 \text{ and } 0.257 \leq d/\lambda \leq 0.300.$$

3. The Lamb wave device according to Claim 1,
wherein the piezoelectric thin film (3) is formed of $LiTaO_3$,
the IDT electrode (4) is formed of Al or an alloy containing Al as a primary component, and
when the thickness of the IDT electrode (4) is represented by h, the thickness of the piezoelectric thin film (3) is represented by d, and the wavelength of a usage mode of the Lamb wave is represented by $\lambda$, h and d satisfy one of the following conditions IV to VI:

$$IV \quad 0.01 \leq h/d \leq 0.26 \text{ and } 0.093 \leq d/\lambda \leq 0.125$$

$$V \quad 0.01 \leq h/d \leq 0.26 \text{ and } 0.141 \leq d/\lambda \leq 0.240$$

$$VI \quad 0.01 \leq h/d \leq 0.26 \text{ and } 0.260 \leq d/\lambda \leq 0.300.$$

4. The Lamb wave device according to one of Claims 1 to 3,
wherein the IDT electrode is formed on the second surface (3b) of the piezoelectric thin film.

5. The Lamb wave device according to one of Claims 1 to 3,
wherein the IDT electrode is formed on the first surface (3a) of the piezoelectric thin film.


**Patentansprüche**

1. Lambwellen-Vorrichtung (1), umfassend:

ein Basissubstrat (2),
eine piezoelektrische Dünnschicht (3), welche auf dem Basissubstrat (2) gebildet ist und welche einen über dem Basissubstrat schwebenden Abschnitt aufweist, der eine erste, dem Basissubstrat zugewandte Oberfläche (3a) und eine zweite, der ersten Oberfläche gegenüberliegende Oberfläche (3b) aufweist, und
eine IDT-Elektrode (4), welche wenigstens auf einer von der der ersten und der zweiten Oberfläche (31, 3b) der piezoelektrischen Dünnschicht (3) angeordnet ist,
wobei die piezoelektrische Dünnschicht (3) aus $LiTaO_3$ oder $LiNbO_3$ gebildet ist,
**dadurch gekennzeichnet, daß**
die c-Achse der piezoelektrischen Dünnschicht in annähernd derselben Richtung eingestellt ist wie die der Flächennormalen der ersten und der zweiten Oberfläche der piezoelektrischen Dünnschicht, und
die Kristallstruktur der Dünnschicht ein Rotations-Zwillings-Kristall ist, bei welchem die c-Achse als Rotationsachse fungiert.

2. Lambwellen-Vorrichtung nach Anspruch 1,
wobei
die piezoelektrische Dünnschicht (3) aus $LiNbO_3$ gebildet ist,

die IDT-Elektrode (4) aus Al oder einer Al als Hauptkomponente enthaltenden Legierung gebildet ist und,
wenn die Dicke der IDT Elektrode (4) durch h repräsentiert ist, die Dicke der piezoelektrischen Dünnschicht (3) durch d repräsentiert ist, und die Wellenlänge einer Anwendungsmode der Lambwelle durch λ repräsentiert ist, h und d eine der folgenden Bedingungen I bis III erfüllen:

$$\text{I.} \quad 0,01 \leq h/d \leq 0,24 \text{ und } 0,090 \leq d/\lambda \leq 0,107$$

$$\text{II.} \quad 0,01 \leq h/d \leq 0,24 \text{ und } 0,133 \leq d/\lambda \leq 0,233$$

$$\text{III.} \quad 0,01 \leq h/d \leq 0,24 \text{ und } 0,257 \leq d/\lambda \leq 0,300.$$

3. Lambwellen-Vorrichtung nach Anspruch 1,
   wobei
   die piezoelektrische Dünnschicht (3) aus LiTaO$_3$ gebildet ist,
   die IDT-Elektrode (4) aus Al oder einer Al als Hauptkomponente enthaltenden Legierung gebildet ist und,
   wenn die Dicke der IDT Elektrode (4) durch h repräsentiert ist, die Dicke der piezoelektrischen Dünnschicht (3) durch d repräsentiert ist, und die Wellenlänge einer Anwendungsmode der Lambwelle durch λ repräsentiert ist, h und d eine der folgenden Bedingungen IV bis VI erfüllen:

$$\text{IV.} \quad 0,01 \leq h/d \leq 0,26 \text{ und } 0,093 \leq d/\lambda \leq 0,125$$

$$\text{V.} \quad 0,01 \leq h/d \leq 0,26 \text{ und } 0,141 \leq d/\lambda \leq 0,240$$

$$\text{VI.} \quad 0,01 \leq h/d \leq 0,26 \text{ und } 0,260 \leq d/\lambda \leq 0,300.$$

4. Lambwellen-Vorrichtung nach einem der Ansprüche 1 bis 3,
   wobei die IDT-Elektrode auf der zweiten Oberfläche (3b) der piezoelektrischen Dünnschicht ausgebildet ist.

5. Lambwellen-Vorrichtung nach einem der Ansprüche 1 bis 3,
   wobei die IDT-Elektrode auf der ersten Oberfläche (3a) der piezoelektrischen Dünnschicht ausgebildet ist.

**Revendications**

1. Dispositif à ondes de Lamb (1) comprenant :

   un substrat de base (2) ;
   une couche mince piézoélectrique (3) qui est formée sur le substrat de base (2) et qui a une partie flottante flottant au-dessus du substrat de base, la partie flottante ayant une première surface (3a) faisant face au substrat de base et une deuxième surface (3b) opposée à la première surface ; et
   une électrode IDT (4) disposée sur au moins l'une des première et deuxième surfaces (3a, 3b) de la couche mince piézoélectrique,
   la couche mince piézoélectrique (3) étant formée de LiTaO$_3$ ou de LiN$_b$O$_3$,
   **caractérisé en ce que** l'axe c de la couche mince piézoélectrique est défini approximativement dans la même direction que la normale aux première et deuxième surfaces de la couche mince piézoélectrique, et la structure cristalline de la couche mince piézoélectrique est un cristal macle par rotation dont l'axe c sert d'axe de rotation.

2. Dispositif à ondes de Lamb selon la revendication 1, dans lequel la couche mince piézoélectrique (3) est formée de LiNbO$_3$, l'électrode IDT (4) est formée d'Al ou d'un alliage contenant de l'Al comme composant principal, et lorsque l'épaisseur de l'électrode IDT (4) est représentée par h, l'épaisseur de la couche mince piézoélectrique (3) est représentée par d, et la longueur d'onde d'un mode d'utilisation de l'onde de Lamb est représentée par λ, h et d satisfont à l'une des conditions I à III suivantes :

$$\text{I.} \quad 0{,}01 \leq h/d \leq 0{,}24 \text{ et } 0{,}090 \leq d/\lambda \leq 0{,}107$$

$$\text{II.} \quad 0{,}01 \leq h/d \leq 0{,}24 \text{ et } 0{,}133 \leq d/\lambda \leq 0{,}233$$

$$\text{III.} \quad 0{,}01 \leq h/d \leq 0{,}24 \text{ et } 0{,}257 \leq d/\lambda \leq 0{,}300.$$

3. Dispositif à ondes de Lamb selon la revendication 1, dans lequel
la couche mince piézoélectrique (3) est formée de $LiTaO_3$,
l'électrode IDT (4) est formée d'Al ou d'un alliage contenant de l'Al comme composant principal, et
lorsque l'épaisseur de l'électrode IDT (4) est représentée par h, l'épaisseur de la couche mince piézoélectrique (3) est représentée par d, et la longueur d'onde d'un mode d'utilisation de l'onde de Lamb est représentée par λ, h et d satisfont à l'une des conditions IV à VI suivantes :

$$\text{IV.} \quad 0{,}01 \leq h/d \leq 0{,}26 \text{ et } 0{,}093 \leq d/\lambda \leq 0{,}125$$

$$\text{V.} \quad 0{,}01 \leq h/d \leq 0{,}26 \text{ et } 0{,}141 \leq d/\lambda \leq 0{,}240$$

$$\text{VI.} \quad 0{,}01 \leq h/d \leq 0{,}26 \text{ et } 0{,}260 \leq d/\lambda \leq 0{,}300.$$

4. Dispositif à ondes de Lamb selon l'une des revendications 1 à 3, dans lequel l'électrode IDT est formée sur la deuxième surface (3b) de la couche mince piézoélectrique.

5. Dispositif à ondes de Lamb selon l'une des revendications 1 à 3, dans lequel l'électrode IDT est formée sur la première surface (3a) de la couche mince piézoélectrique.

## FIG.1

## FIG.2

LiNbO₃ THIN FILM (0 1 14)

φ [DEGREES]

## FIG.3A

## FIG.3B

## FIG.3C

## FIG.4

Al/LiNbO₃ TWIN CRYSTAL    d∕λ=0.10

## FIG.5

## FIG.6

## FIG.7

Legend:
- —— A1
- — — A0 (3)
- ------ A0 (5)
- —·— A0 (7)
- —··— A1 (3)
- —— S0 (3)
- ········ S1 (5)
- —··—··— S2

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5003822 A

- JP 2002152007 A

**Non-patent literature cited in the description**

- Analysis of Lamb wave propagation characteristics in rotated Y-cut X-propagation LiNbO3 plate. *The Journal of the Institute of Electrical Communication Engineers of Japan,* May 1985, vol. J68-A (5), 496-503